(19) Europäisches Patentamt / European Patent Office / Office européen des brevets

(11) **EP 2 731 165 A1**

(12) **EUROPEAN PATENT APPLICATION**
published in accordance with Art. 153(4) EPC

(43) Date of publication:
**14.05.2014 Bulletin 2014/20**

(51) Int Cl.:
*H01M 2/10* (2006.01)  *H01M 2/30* (2006.01)
*H01M 10/44* (2006.01)  *H02J 7/02* (2006.01)

(21) Application number: **12810559.0**

(22) Date of filing: **03.07.2012**

(86) International application number:
**PCT/JP2012/004291**

(87) International publication number:
**WO 2013/008409 (17.01.2013 Gazette 2013/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.07.2011  JP 2011152373**

(71) Applicant: **NEC Energy Devices, Ltd.**
**Chuo-ku**
**Sagamihara-shi**
**Kanagawa 252-5298 (JP)**

(72) Inventor: **YOSHIDA, Tadahiro**
**Kanagawa 252-5298 (JP)**

(74) Representative: **Vossius & Partner**
**Siebertstrasse 4**
**81675 München (DE)**

(54) **METHOD FOR MANUFACTURING BATTERY PACK AND BATTERY PACK**

(57)   A battery pack that has multiple battery units that differ in full charge capacity is charged and discharged to the maximum. A method of manufacturing the battery pack includes the following steps. First, battery cells that differ in full charge capacity are individually charged to be charged up to the full charge capacity (a charge step, S120). Subsequently, the multiple battery cells that become charged to the full charge capacity are connected in series to one another (a connection step, S130).

FIG. 2

EP 2 731 165 A1

**Description**

TECHNICAL FIELD

The present invention relates to a method of manufacturing a battery pack and a battery pack.

BACKGROUND ART

Various charge and discharge methods or control circuits for preventing overcharge and over discharge of a battery have been proposed.

A battery pack charge balance circuit described below is disclosed in Patent Document 1 (Japanese Unexamined Patent Application Publication No. 2009-232559). The battery pack charge balance circuit includes a first balance control circuit, a second balance control circuit, and a protection circuit. The first balance control circuit and the second balance control circuit are connected in series between both a charge terminal and a discharge terminal of a charge and discharge circuit. The first balance control circuit has control units that are connected in parallel, corresponding to multiple battery units. The second balance control circuit has a first branch and a second branch that are connected in parallel. Accordingly, branching can be performed on the battery unit that reaches an unbalanced protection activation voltage that is set in advance, and the protection circuit can be prevented from activating an overcharge protection function earlier. Therefore, the charge of each battery unit can be balanced.

Furthermore, a method of replacing a rechargeable battery, described below, is disclosed in Patent Document 2 (Japanese Unexamined Patent Application Publication No. 2009-277627). First, a rechargeable battery that is reusable for an assembled battery is discharged as a reusable object for itself or for another assembled battery, until the rechargeable battery becomes completely discharged. Subsequently, the rechargeable battery in the completely discharged state is stored in a storage region to allow a predetermined period of time or more to elapse from the time of the completely discharged state. Subsequently, the rechargeable battery itself stored in the completely discharged state, another rechargeable battery that is reusable, or a new rechargeable battery is combined for reconfiguration of the assembled battery. Accordingly, the assembled battery with sufficient performance can be easily reconfigured.

Furthermore, a lithium ion battery pack described below is disclosed in Patent Document 3 (Japanese Unexamined Patent Application Publication No. 11-234916). A resistor, a switch element, and a control circuit are provided to each battery cell. When a voltage between both electrodes of the battery cell is a predetermined value or above, the control circuit short-circuits both of the electrodes of the battery cell through the resistor, by allowing electricity to flow through the switch element. Furthermore, the control unit performs control to determine whether to short-circuit both of the electrodes or to charge the battery cell according to both voltages of the battery cell. Accordingly, by adjusting a charge speed among the battery cells while the charge of the battery cells is in progress, amounts of charge of all the battery cells can be prepared equally in a short period of time.

RELATED DOCUMENT

PATENT DOCUMENT

[Patent Document 1] Japanese Unexamined Patent Application Publication No. 2009-232559
[Patent Document 2] Japanese Unexamined Patent Application Publication No. 2009-277627
[Patent Document 3] Japanese Unexamined Patent Application Publication No. 11-234916

DISCLOSURE OF THE INVENTION

The inventors found out that the following problems occur in a battery pack in which battery units that differ in full charge capacity are connected in series to one another. In the case of connecting the battery units in series, particularly the battery unit that has the smallest full charge capacity increases more rapidly in charge voltage than the other battery units. Because of this, when charging the battery pack, the charge is terminated at the timing when the battery unit that has the smallest full charge capacity reaches an overcharge protection voltage. At this time, there is a likelihood that all the battery cells will remain in a state where the charge is insufficient.

According to the present invention, there is provided a method of manufacturing a battery pack, including a charge step of individually charging battery units that differ in full charge capacity to charge the battery units up to the full charge capacity, and a connection step of connecting in series the multiple battery units that reach the full charge capacity.

According to the present invention, there is provided a battery pack including multiple battery units that are connected in series to one another, in which the multiple battery units individually differ in full charge capacity, and amounts of difference, each of which results from subtracting a current amount of charge from the full charge capacity of each of the battery units, are mutually substantially the same.

According to the present invention, the multiple battery units that differ in full charge capacity are individually charged up to the full charge capacity and then are connected in series to one another to form the battery pack. Therefore, the amount of charge of the battery pack that has the multiple battery units that differ in full charge capacity can be increased.

According to the present invention, an amount of charge of the battery pack that has the multiple battery units that differ in full charge capacity can be increased.

BRIEF DESCRIPTION OF THE DRAWINGS

The objects described above, other objects, features and advantages are made apparent by suitable embodiments described below and the accompanying drawings.

Fig. 1 is a circuit diagram illustrating a configuration of a battery pack according to a first embodiment.
Fig. 2 is a flow chart illustrating a charge method according to the first embodiment.
Fig. 3 is a view illustrating a charge step according to the first embodiment.
Fig. 4 is a view of a comparative example for describing an effect according to the first embodiment.
Fig. 5 is a view illustrating the time of discharge of the battery pack according to the first embodiment.
Fig. 6 is a view illustrating a step of recharging the battery pack according to the first embodiment.
Fig. 7 is a flow chart illustrating a charge method according to a second embodiment.
Fig. 8 is a circuit diagram illustrating a configuration of a battery pack according to a third embodiment.
Fig. 9 is a flow chart illustrating a charge method according to the third embodiment.
Fig. 10 is a flow chart illustrating the charge method according to the third embodiment.
Fig. 11 is a view for describing the charge method according to the third embodiment.
Fig. 12 is a circuit diagram illustrating configurations of a battery pack and a control circuit according to a fourth embodiment.
Fig. 13 is a circuit diagram illustrating configurations of a battery pack and a control circuit according to a fifth embodiment.

DESCRIPTION OF EMBODIMENTS

Embodiments of the present invention are described below referring to the drawings. Moreover, in all the drawings, like constituent elements are given like reference numerals and descriptions thereof will not be repeated.

The "battery pack 10" here refers to an assembled battery that has multiple battery units. Furthermore, the "battery unit" refers to one that has at least one or more battery cell 100. In addition, the battery cell 100 included in the "battery unit" may have multiple unit cells, each having a positive electrode, a negative electrode, and the like. Furthermore, each of the multiple "battery units" may have the different number of the battery cell 100. A case is described below in which the "battery unit" included in the "battery pack 10" is the battery cell 100 that has the two unit cells that are connected in parallel to each other.

(First Embodiment)

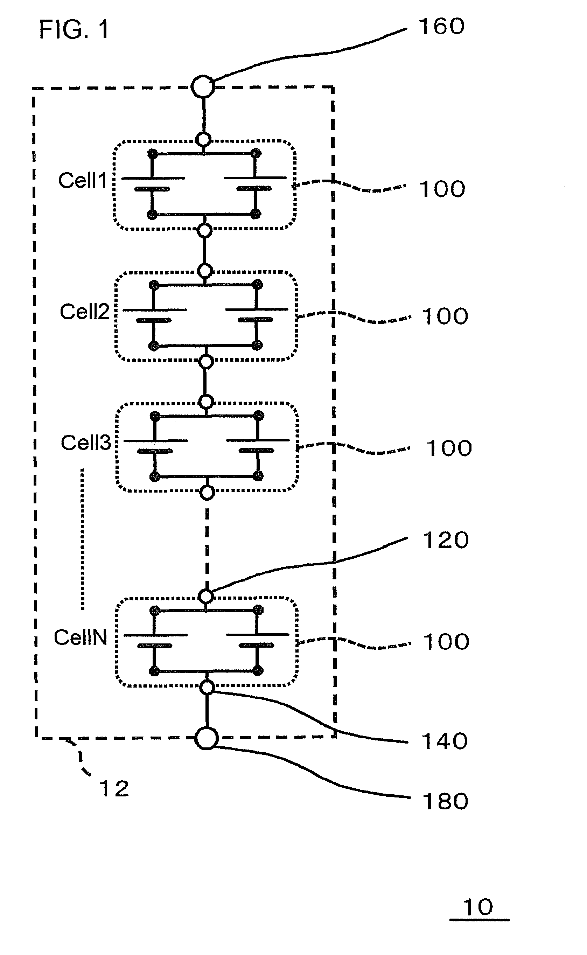

The battery pack 10 according to the first embodiment is described referring to Fig. 1. Fig. 1 is a circuit diagram illustrating a configuration of the battery pack 10 according to the first embodiment. The battery pack 10 includes the multiple battery cells 100 that are connected in series to one another. The battery cells 100 individually differ in full charge capacity. The battery cells 100 are connected in series to one another after they are individually charged to be charged up to the full charge capacity. Because of this, in each battery cell, amounts of difference, each of which results from subtracting a current amount of charge from the full charge capacity, are mutually substantially the same. A detailed description is provided below.

As illustrated in Fig. 1, the battery pack 10 includes the multiple battery cells 100. Specifically, the battery pack 10 includes, for example, N battery cells 100. Furthermore, the battery cell 100 has the two unit cells as illustrated above. Specifically, the battery cell 100 is, for example, a Li ion rechargeable battery.

The multiple battery cells 100 are accommodated within an exterior body 12 of the battery pack 10.

The multiple battery cells 100 are connected in series to one another. A positive terminal 120 of the battery cell 100 is provided toward the positive electrode of the battery cell 100. On the other hand, a negative terminal 140 of the battery cell 100 is provided toward the negative electrode of the battery cell 100. The negative terminal 140 of the battery cell 100 of Cell 1 and the positive terminal 120 of the battery cell 100 of Cell 2 are connected to each other. The battery cells 100 are sequentially connected in series to one another in this manner. The negative terminal 140 of the battery cell 100 of Cell N-1 and the positive terminal 120 of the battery cell 100 of Cell N are connected to each other.

Furthermore, the positive terminal 120 of the battery cell 100 of Cell 1 that is provided nearest to the positive electrode is connected to an external positive terminal 160. On the other hand, the negative terminal 140 of the battery cell 100 of Cell N that is provided nearest to the negative electrode is connected to an external negative terminal 180. Furthermore, the external positive terminal 160 and the external negative terminal 180 are exposed from the exterior body 12 of the battery pack 10. Accordingly, the external positive terminal 160 and the external negative terminal 180 can be connected to a positive terminal and a negative terminal of an external apparatus, respectively. Moreover, the "battery cell 100 nearest to the positive electrode" refers to the battery cell 100 that is positioned toward the highest electric potential, among the battery cells 100 that are connected in series to one another. Furthermore, the "battery cell 100 nearest to the negative electrode" refers to the battery cell 100 that is positioned toward the lowest electric potential, among the battery cells 100 that are connected in series to one another.

According to the first embodiment, as described below, the battery cells 100 that differ in full charge capacity are connected in series to one another after they are individually charged to be charged up to the full charge capacity. Therefore, the amounts of difference, each of which results from subtracting the current amount of charge from the full charge capacity of each battery cell 100, are mutually substantially the same. An effect of the battery pack 10 is described in detail below.

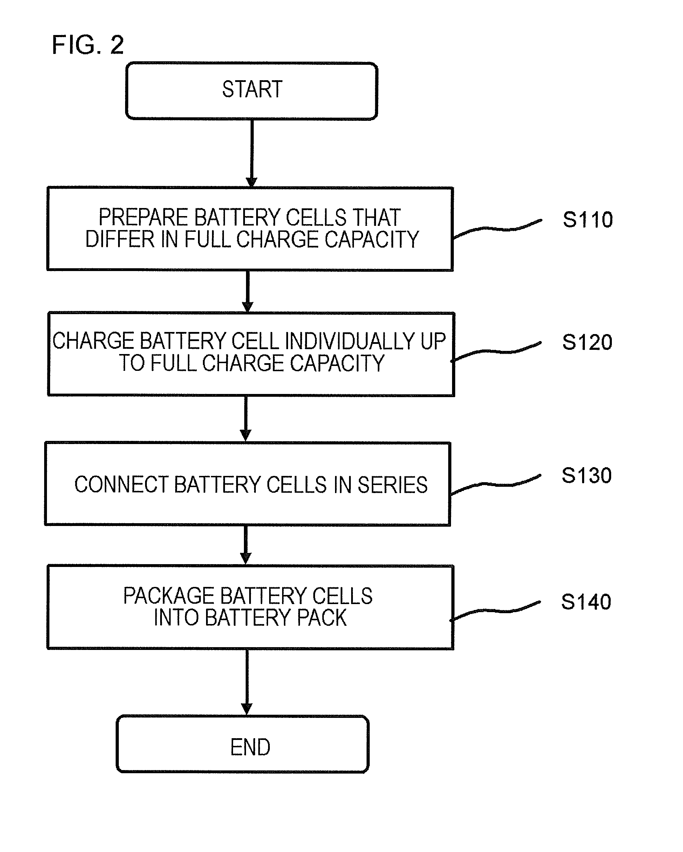

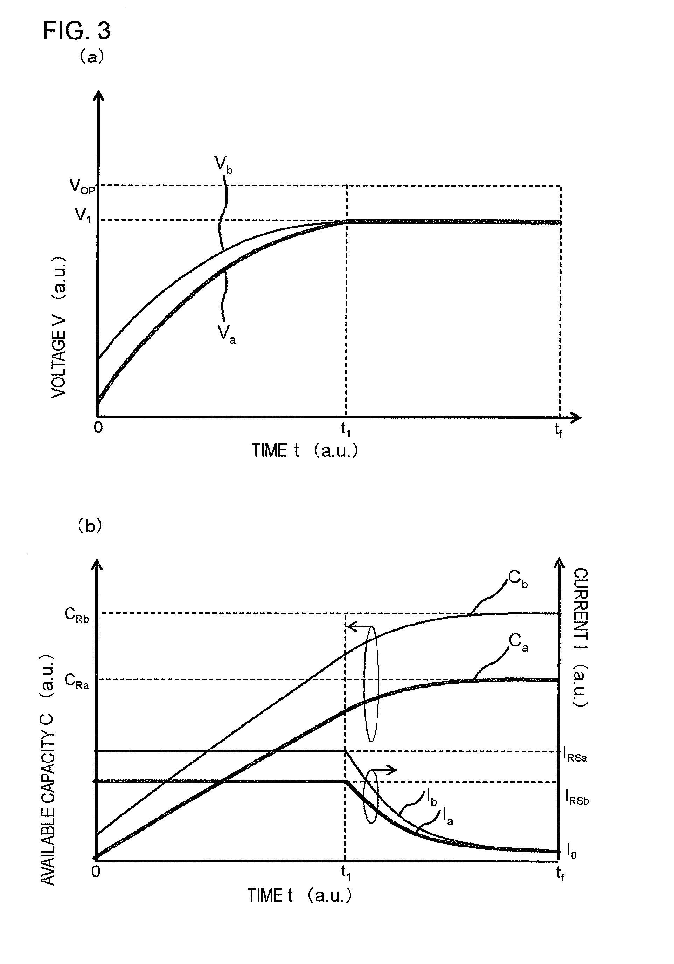

Next, a method of manufacturing the battery pack 10 according to the first embodiment is described referring to Fig. 2 and Fig. 3. Fig. 2 is a flowchart illustrating a charge method according to the first embodiment. Fig. 3 is a view illustrating a charge step according to the first embodiment. The method of manufacturing the battery pack 10 according to the first embodiment includes a charge step (S120) and a connection step (S130). In the charge step (S120), the battery cells 100 that differ in full charge capacity are individually charged to be charged up to the full charge capacity. In the connection step (S130), the multiple battery cells 100 that become charged up to the full charge capacity are connected in series to one another. The steps S120 and S130 are described in detail below.

First, the battery cells 100 that differ in full charge capacity are prepared (S110). Here, for example, so-called brand-new battery cells 100, which differ in full charge capacity, are prepared. Furthermore, the "brand-new battery cells" here refer to battery cells 100 that have not been charged and discharged by a user after manufacturing.

Subsequently, the battery cells 100 that differ in full charge capacity are individually charged to be charged up to the full charge capacity (the charge step, S120). Here, Fig. 3(a) illustrates a relationship between time and a voltage of the battery cell 100 after starting charge in the charge step. Fig. 3 (b) illustrates a relationship between time and available capacity of the battery cell 100 after starting charge and a relationship between time and current in the battery cell 100 after starting charge. Furthermore, Fig. 3(a) and Fig. 3(b) illustrate a case where constant-voltage constant-current charging is performed on each battery cell 100, for example, using a different battery charger. However, Fig. 3 (a) and Fig. 3 (b) illustrate a case where the charging is performed under the condition that a charge voltage with respect to each battery cell 100 is the same constant voltage (a first reference voltage $V_1$) and a charge current with respect to each battery cell 100 is a different current.

In Fig. 3, among the battery cells 100 that differ in full charge capacity, the battery cell that is smallest in full charge capacity is defined as a capacity-minimum cell (a) and the battery cell that is highest in full charge capacity is defined as a capacity-maximum cell (b). Furthermore, voltage, available capacity, and current of each cell are defined as $V_a$ and $V_b$, $C_a$ and $C_b$, and $I_a$ and $I_b$, respectively. Furthermore, time is defined as $t_1$.

As illustrated in Fig. 3(a), since the battery cells 100 differ in full charge capacity, Voltages $V_a$ and $V_b$ of the battery cell 100 differ. In the charge step (S120), the battery cells 100 are individually charged. The voltages $V_a$ and $V_b$ increase sharply until time $t_1$. Then, at the time $t_1$, the voltages $V_a$ and $V_b$ of each of the battery cells 100 become the first reference voltage $V_1$. At and after the time $t_1$, constant voltage charge is performed. Because of this, each current decreases gradually. Furthermore, the available capacity also increases gradually. At time $t_f$, the charging is performed until current becomes a charge stopping current $I_0$. Accordingly, each battery cell 100 is charged up to the full charge capacity.

In this manner, a voltage of the battery cell 100 at the full charge capacity is the first reference voltage $V_1$ that is below an overcharge protection voltage $V_{OP}$. Here, the "first reference voltage $V_1$" is a reference value of a voltage that is set to be below the overcharge protection voltage $V_{OP}$. Specifically, the "first reference voltage $V_1$" is, for example, a rated charge voltage. Accordingly, because each battery cell 100 is not charged up to a voltage near overcharge, deterioration of the battery cell 100 can be suppressed. Moreover, the "rated charge voltage" is a voltage at which the charge is possible, which is set to be below the overcharge protection voltage $V_{OP}$, taking safety into consideration, at the time of charging the battery pack 10.

Here, the "overcharge protection voltage $V_{OP}$" is an upper limit value that is imposed on the voltage in order to prevent a defect, such as smoking, ignition, or explosion, from occurring, for example, in the lithium ion rechargeable battery and the like. When the battery cell 100, the lithium ion rechargeable battery, is in an overcharge state, lithium in the form of a dendrite occurs and the positive electrode and the negative electrode are short-circuited. In this case, there is a risk that heat may be generated due to the short-circuit and the battery pack 10 may be exploded. Because of this, an "overcharge protection voltage $V_{OP}$," as a maximum value of the charge voltage, is set.

Furthermore, as illustrated in Fig. 3 (b), in the charge step (S120), because the constant current charge is performed until the time $t_1$, a charge current $I_{RSa}$ and a charge current $I_{RSb}$ are constant until the time $t_1$. Furthermore, available capacity $C_a$ and available capacity $C_b$ increase linearly until the time $t_1$. Subsequently, because constant voltage charge is performed at and after the time $t_1$, as the battery cell 100 becomes gradually nearer the full charge capacity, each of the charge current $I_{RSa}$ and the charge current $I_{RSb}$ decreases monotonously. Furthermore, at and after the time $t_1$, the available capacity $C_a$ and the available capacity $C_b$ increase gradually. Then, at the time $t_f$, the available capacity $C_a$ and the available capacity $C_b$ become full charge capacity $C_{Ra}$ and full charge capacity $C_{Rb}$, respectively. Furthermore, at the time $t_f$, current $I_a$ and current $I_b$ decrease until a charge stopping current $I_0$. In this manner, the battery cells 100 are individually charged.

Subsequently, the multiple battery cells 100 that reach the full charge capacity are connected in series to one another (the connection step, S130). In a full charge state, the connections between the multiple battery cells 100 entails a risk, such as one of short-circuiting the positive terminal 120 and negative terminal 140 with respect to each other. Because of this, in the connection step (S130), it is preferable that while the positive terminal 120 in the battery cell 100 nearest to the positive electrode and the negative terminal 140 in the battery cell 100 nearest to the negative electrode are protected with an insulation cover, the multiple battery cells 100 be sequentially connected in series.

Subsequently, after the connection step (S130), the multiple battery cells 100 are accommodated within the exterior body 12. Along with this, the external positive terminal 160 that is connected to the positive terminal 120 of the battery cell 100 that is provided nearest to the positive electrode and the external negative terminal 180 that is connected to the negative terminal 140 of the battery cell 100 that is provided nearest to the negative electrode are provided in such a manner that the external positive terminal 160 and the external negative terminal 180 are exposed from the exterior body 12 (a package step, S140).

As described above, the battery pack 10 according to the first embodiment is obtained.

Next, an effect according to the first embodiment is described, compared to a comparative example, referring to Fig. 3 to Fig. 6.

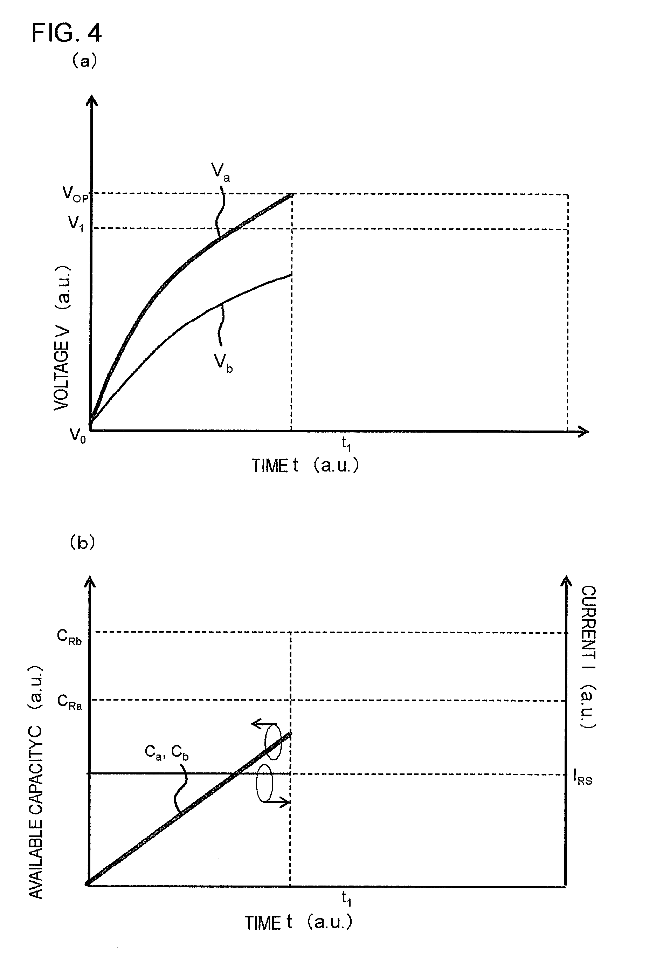

First, the comparative example is described referring to Fig. 4. Fig. 4 is a view of the comparative example for describing the effect according to the first embodiment.

The comparative example is a case when, for example, the battery pack 10 is manufactured with the following steps. First, the battery cells 100 that differ in full charge capacity are prepared. Subsequently, each battery cell 100 is completely discharged. Moreover, the expression "completely discharged" is used to mean that the discharge is performed until the voltage of the battery cell 100 becomes a discharge stopping voltage $V_0$. Subsequently, before the charge step, the completely discharged multiple battery cells 100 are connected in series to one another. Subsequently, the multiple battery cells 100 are accommodated within the exterior body 12 of the battery pack 10. Subsequently, the battery pack 10 is charged with a constant current. The battery pack 10 in the comparative example that is manufactured in this manner is considered.

Fig. 4(a) illustrates a relationship between time and a voltage of the battery cell 100 after starting charge in the charge step in the comparative example. Fig. 4(b) illustrates a relationship between time and available capacity of the battery cell 100 after starting charge and a relationship between time and current in the battery cell 100 after starting charge in the charge step in the comparative example.

As illustrated in Fig. 4(a), since in the comparative example, the complete discharge is performed before charging, in the charge step in the comparative example, each initial value of the voltages $V_a$ and $V_b$ of the battery cell 100 becomes a value that is near the discharge stopping voltage $V_0$. Specifically, the charge is started from a voltage that results from adding an amount of voltage drop due to internal resistance, which occurs at the time of the discharge, to the discharge stopping voltage $V_0$. The "discharge stopping voltage $V_0$" here is a voltage at which the discharge is possible, which is set to be above an overdischarge voltage, taking safety into consideration, at the time of the discharge in the lithium ion rechargeable battery.

In the comparative example, in the charge step, all the battery cells 100 that are completely discharged and connected in series are charged at one time. Because of this, a voltage $V_a$ of the capacity-minimum cell (a) increases more rapidly than $V_b$. If the charge is performed as much as possible on each battery cell 100, at the time $t_1$, the voltage $V_a$ of the capacity-minimum cell (a) increases up to the overcharge protection voltage $V_{OP}$. Because of this, the charge with respect to the battery pack 10 is forced to be terminated. Because of this, the charge is terminated before the voltage $V_b$ of the capacity-maximum cell (b) becomes the first reference voltage $V_1$.

Furthermore, as illustrated in Fig. 4 (b), the available capacity of all the battery cells 100 increases linearly due to the charge. However, at the time $t_1$, as described above, the charge is forced to be terminated. Because of this, the charge is terminated before the available capacity of all the battery cells 100 becomes the full charge capacity. In this manner, in the comparative example, the available capacity of the entire post-charge battery pack 10 is smaller than a sum total of all full charge capacities of the battery cells 100.

Furthermore, in the comparative example, in order to perform the charge on the battery pack 10 to the maximum, the charge has to be performed in such a manner that the voltage $V_a$ of the capacity-minimum cell (a) exceeds the first reference voltage $V_1$. That is, in the comparative example, the charge has to be terminated in a state where the capacity-minimum cell (a) is overcharged. Because of this, there is a likelihood that the repetitive performing of the charge will expedite deterioration of the capacity-minimum cell (a).

Furthermore, in the comparative example, the battery cells 100 other than the capacity-minimum cell (a) do not become charged up to the full charge capacity. Because of this, at the time of beginning to use the post-charge battery pack 10, the battery cells 100 other than the capacity-minimum cell (a) begin to be discharged from a low voltage state. Therefore, if the discharge continues, there is a likelihood that the voltage of all the battery cells 100 will drop rapidly.

Next, an operation and an effect according to the first embodiment are described referring to Fig. 3, Fig. 5 and Fig. 6.

As illustrated in Fig. 3, according to the first embodiment, in the charge step (S120), the battery cells 100 that differ in full charge capacity are individually charged to be charged up to the full charge capacity. Accordingly, the amount of charge of the battery pack 10 that has the battery cells 100 that differ in full charge capacity can be increased. Furthermore, because the voltage of each battery cell 100 does not exceed the first reference voltage $V_1$, the deterioration of the battery cell 100 can be suppressed.

In addition, according to the first embodiment, a case is considered in which the battery pack 10 that is charged in the charge step (S120) is discharged at a constant current and is recharged.

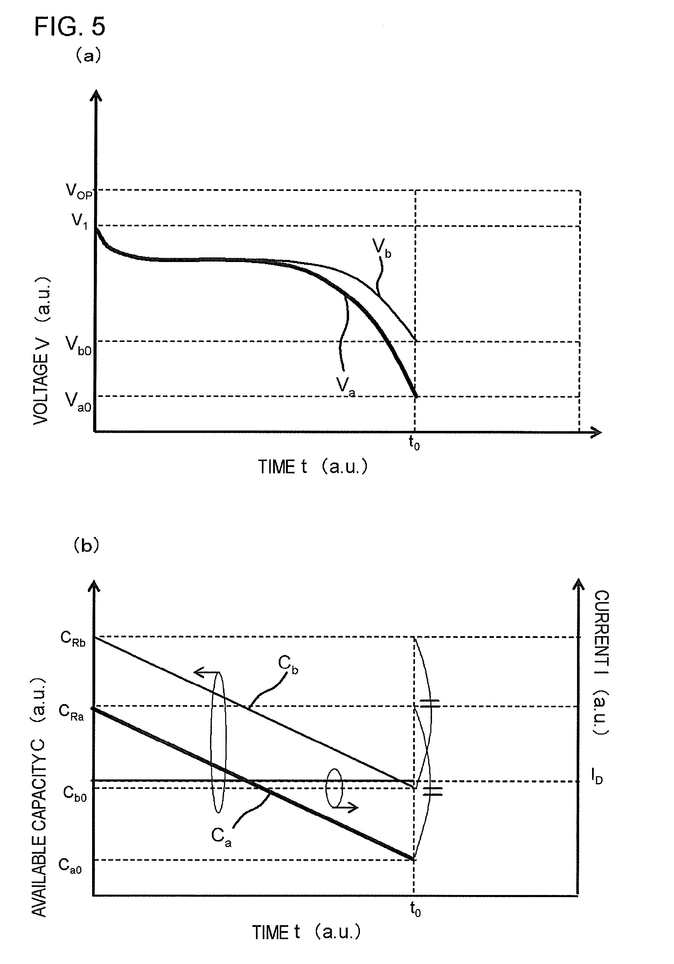

Fig. 5 is a view illustrating the time of the discharge of the battery pack according to the first embodiment. Fig. 5(a) illustrates a relationship between time and a voltage of the battery cell 100 after starting discharge in a case where the battery pack 10 according to the first embodiment is discharged. Fig. 5 (b) illustrates a relationship between time and available capacity of the battery cell 100 after starting discharge and a relationship between time and current in the battery cell 100 after starting discharge in the case where the battery pack 10 according to the first embodiment is discharged.

As illustrated in Fig. 5 (a), all the battery cells 100 that include the capacity-minimum cell (a) and the capacity-maximum cell (b) are charged up to the first reference voltage $V_1$, the full charge capacity, in the charge step (S120) illustrated in Fig. 3. Therefore, at the time of starting discharge, the voltage of each battery cell 100 is a value that is near $V_1$.

As the discharge is performed, the voltage of each battery cell 100 drops. At this time, because the capacity-maximum cell (b) is charged up to the full charge capacity, the voltage $V_b$ drops later in time than those of the other battery cells 100, such as the capacity-minimum cell (a) and the like.

When the discharge is performed until time to, the voltage $V_a$ of the capacity-minimum cell (a) drops down to $V_{a0}$. On the other hand, the voltage $V_b$ of the capacity-maximum cell (b) drops down to $V_{b0}$. At this time, the voltage $V_{b0}$ of the capacity-maximum cell (b) is higher than the voltage $V_{a0}$ of a capacity-minimum cell. In this manner, in the battery pack 10 according to the first embodiment, the high voltage can be maintained for a long time at the time of the discharge, compared to the battery pack 10 in the comparative example.

On the other hand, as illustrated in Fig. 5(b), since the battery cells 100 are connected in series to one another, the current in each battery cell 100 at the time of the discharge is a constant discharge current $I_D$.

Furthermore, the available capacity of each battery cell 100 drops linearly. For example, available capacity $C_a$ of the capacity-minimum cell (a) and available capacity $C_b$ of the capacity-maximum cell (b) drop linearly due to the discharge. At the time to, the available capacity $C_a$ of the capacity-minimum cell (a) and the available capacity $C_b$ of the capacity-maximum cell (b) become $C_{a0}$ and $C_{b0}$.

At this time, the battery cells 100 are equal in amount of discharge to one another. In other words, in each battery unit, the amounts of difference, each of which results from subtracting the current amount of charge from the full charge capacity (that is, an amount of discharge until the time to), is mutually substantially the same. The amount of difference is preferably mutually the same. The expression "substantially the same" here refers to the same range that includes a range of dispersion in terms of the amount of discharge that occurs between the battery cells 100 at the time of discharging the battery pack 10 according to the present embodiment. Furthermore, the "range of dispersion," for example, can be defined as meaning "a difference between maximum and minimum values of the amount of difference in each battery cell 100 falls within 3% or less of a rated full charge capacity" and the like. Here, the battery cells 100 that differ in full charge capacity differ, for example, in internal resistance. Because of this, it is considered that the amounts of discharge that result until the time to differ, by a loss of the internal resistance of each battery cell 100, among the battery cells 100. Because of this, the amounts of difference, each of which results from subtracting the current amount of charge from the full charge capacity may not be mutually completely the same. In this case, the amount of difference may be substantially the same, in a range where the loss due to the internal resistance of the battery cell 100 and the like are added up.

For example, the available capacity $C_a$ of the capacity-minimum cell (a) and the available capacity $C_b$ of the capacity-maximum cell (b) satisfies the following formula (1). (However, as described above, $C_{Ra}$, $C_{a0}$, $C_{Rb}$ and $C_{b0}$ are the full charge capacity of the capacity-minimum cell (a), the available capacity of the capacity-minimum cell (a) at the time to when the discharge is performed, the full charge capacity of the capacity-maximum cell (b), and the available capacity of the capacity-maximum cell (b) at the time to when the discharge is performed, respectively).

$$C_{Ra} - C_{a0} = C_{Rb} - C_{b0} \quad (1)$$

Moreover, the left side and the right side of the formula (1) may be not only completely equal to each other, but may be equal to each other also in the range of dispersion described above.

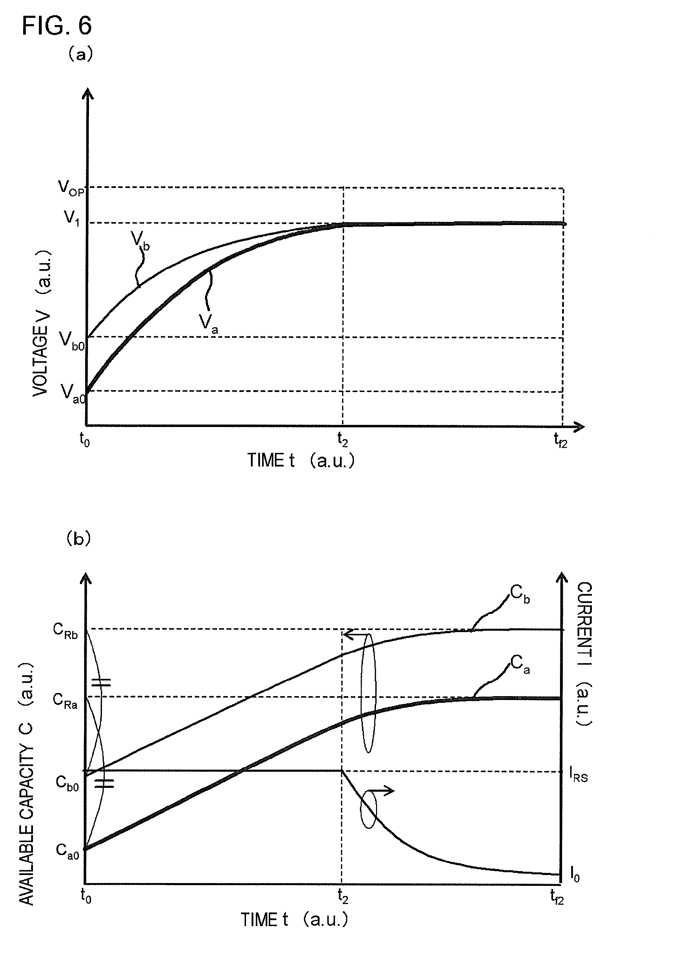

Next, referring to Fig. 6, a case is considered in which the battery pack 10 according to the first embodiment is recharged. Fig. 6 is a view illustrating a step of recharging the battery pack according to the first embodiment. Fig. 6(a) illustrates a relationship of time and a voltage of the battery cell 100 after starting recharge in a case where the battery pack 10 according to the first embodiment is recharged. Fig. 6(b) illustrates a relationship between time and available capacity of the battery cell 100 after starting recharge and a relationship between time and current in the battery cell 100 after staring recharge in a case where the battery pack 10 according to the first embodiment is recharged.

As illustrated in Fig. 6(a), the voltage $V_a$ of the capacity-minimum cell (a) is $V_{a0}$ at the time to after the discharge. Furthermore, at this time, the voltage $V_b$ of the capacity-maximum cell (b) is $V_{b0}$. At the time to after the discharge, the voltage $V_{a0}$ of the capacity-minimum cell (a) is smaller than the voltage $V_{b0}$ of the capacity-maximum cell (b).

In the same manner as in the charge step in Fig. 3, in the recharge step, the voltage $V_a$ of the capacity-minimum cell (a) increases more rapidly than the voltage $V_b$ of the capacity-maximum cell (b). Because the battery cells 100 are equal to one another in terms of the amount of discharge, each battery cell 100 reaches the first reference voltage $V_1$ at almost the same timing. For example, the voltage $V_a$ of the capacity-minimum cell (a) and the voltage $V_b$ of the capacity-maximum cell (b) reaches the first reference voltage $V_1$ at time $t_2$.

As illustrated in Fig. 6(b), in the recharge step, since the battery cells 100 are connected in series to one another, the battery cells 100 are equal to one another in terms of current flowing through them. In the recharge step, because the constant current charge is performed until the time $t_2$, the current flowing in each battery cell 100 is constant as charge current $I_{RS}$. Furthermore, the available capacity $C_a$ and the available capacity $C_b$ increase linearly until the time $t_2$. Then, since the battery cells 100 are equal to one another in terms of the amount of discharge, each battery cell 100 reaches the first reference voltage $V_1$ at almost the same timing. Subsequently, because the constant voltage charge is performed at and after the time $t_2$, as each battery cell 100 becomes gradually nearer the full charge capacity, the current decreases at a constant rate. Furthermore, at and after the time $t_2$, the available capacity $C_a$ and the available capacity $C_b$ increase gradually. Here, at time $t_{f2}$, the available capacity $C_a$ and the available capacity $C_b$ become the full charge capacity $C_{Ra}$ and the full charge capacity $C_{Rb}$, respectively.

As described above, in each battery unit, the amounts of difference, each of which results from subtracting the current amount of charge from the full charge capacity, are mutually substantially the same. Accordingly, when recharging the battery pack 10, each battery cell 100 can be charged up to the full charge capacity at almost the same timing. In this manner, the battery cells 100 that differ in full charge capacity can be charged up to the full charge capacity each time the charge is performed repeatedly. That is, because each battery cell 100 can be used from a state of full charge capacity, a state of high voltage at the time of the discharge can be maintained for a long time.

As described above, according to the first embodiment, the battery pack 10 that has the multiple battery cells 100 that differ in full charge capacity can be charged and discharged to the maximum.

(Second Embodiment)

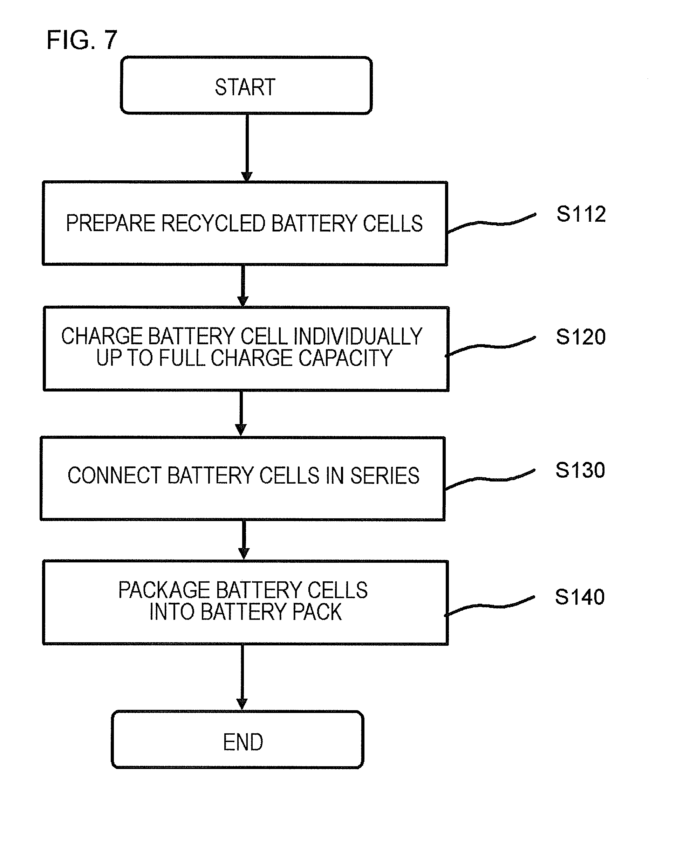

A battery pack 10 according to the second embodiment is described referring to Fig. 7. Fig. 7 is a flow chart illustrating a charge method according to the second embodiment. The second embodiment is the same as the first embodiment except that a battery cell 100 is recycled. A detailed description is provided below.

A configuration of the battery pack 10 according to the second embodiment is the same as the configuration of the battery pack 10 according the first embodiment in Fig. 1.

The battery cell 100 according to the second embodiment is, for example, recycled. The expression "recycled" here means that the battery pack 10 that is used up is collected by a manufacturer, and then the battery pack 10 is disintegrated and the battery cell 100 is reused. Furthermore, the expression "the battery pack 10 that is used up" is used to mean the battery pack 10 that is charged or discharged, at least one time or more, by the user. Therefore, the battery pack 10 becomes the assembled battery of the battery cell 100 that is recycled. A case is described below in which the battery cell 100 is recycled.

Furthermore, if the battery cell 100 is recycled, usage time of the battery cells 100 differs among the used-up battery packs 10. Because of this, the extent of deterioration differs. Accordingly, the battery cells 100 differ in full charge capacity.

In the same manner as in the first embodiment, the recycled battery cells 100 are connected in series to one another after they are individually charged to be charged up to the full charge capacity. Therefore, the amounts of difference, each of which results from subtracting the current amount of charge from the full charge capacity of each battery cell 100, are mutually substantially the same.

Next, a method of manufacturing the battery pack 10 according to the second embodiment is described referring to Fig. 7. A detailed description is provided below.

As illustrated in Fig. 7, first, the recycled battery cell 100 is prepared (S112). The expression "prepared" in the case of the recycled battery cell 100 means that the battery cell 100 is disintegrated from the used-up battery pack 10 that is collected. Furthermore, as described above, the "used-up battery pack 10" refers to the battery pack 10 that is repeatedly both charged and discharged, a given number of times, by the user.

Furthermore, in the step (S112) of preparing the recycled battery cell 100, a component of the used-up battery cell 100, such as a positive electrode material, a negative electrode material, an electrolyte, or the like, may be replaced or repaired.

Here, a step of inspecting the full charge capacity of the recycled battery cell 100 may be performed. Specifically, the once-recycled battery cell 100 is completely discharged. Subsequently, a charge step to be described below is performed. Accordingly, the full charge capacity of the recycled battery cell 100 can be appreciated.

Subsequently, the battery cells 100 that differ in full charge capacity are individually charged to be charged up to the full charge capacity (the charge step, S120).

Subsequently, the multiple battery cells 100 that reach the full charge capacity are connected in series to one another (the connection step, S130). In a full charge state, the connections between the multiple battery cells 100 entail a risk, such as one of short-circuiting a positive terminal 120 and negative terminal 140 with respect to each other. Because of this, also in the second embodiment, in a connection step (S130), it is preferable that while the positive terminal 120 and the negative terminal 140 are protected with an insulation cover, the multiple battery cells 100 be sequentially connected in series.

Subsequently, after the connection step (S130), the multiple battery cells 100 are accommodated within the exterior body 12. Along with this, the external positive terminal 160 that is connected to the positive terminal 120 of the battery cell 100 that is provided nearest to the positive electrode and the external negative terminal 180 that is connected to the negative terminal 140 of the battery cell 100 that is provided nearest to the negative electrode are provided in such a manner as to be exposed from the

exterior body 12 (a package step, S140).

As described above, the battery pack 10 according to the second embodiment is obtained.

Next, an effect according to the second embodiment is described.

If the battery cell 100 is recycled, the extent of deterioration differs among the used-up battery packs 10. Because of this, the battery cells 100 differ in full charge capacity. Therefore, according to the second embodiment, the same effect as that according to the first embodiment can be obtained. That is, the battery pack 10 that has the recycled multiple battery cells 100 can be charged and discharged to the maximum.

Furthermore, according to the second embodiment, in a recharge step, the recycled battery cell 100 does not become overcharged. Accordingly, deterioration due to the overcharge can be suppressed. Therefore, the recycled battery cell 100 also can continue to be used for a long time.


(Third Embodiment)

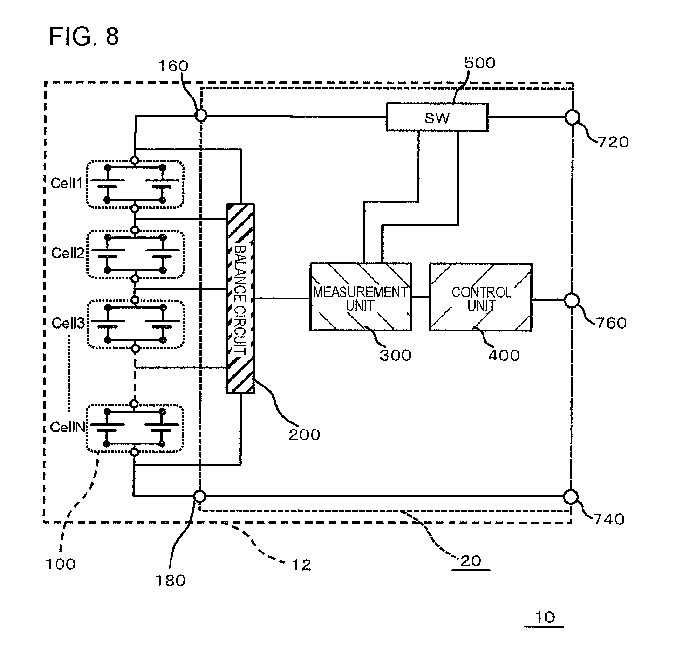

A battery pack 10 according to a third embodiment is described referring to Fig. 8. Fig. 8 is a circuit diagram illustrating a configuration of the battery pack 10 according to the third embodiment. The third embodiment is the same as the first embodiment or the second embodiment except for the following respects. The battery pack 10 according to the third embodiment further includes a balance circuit 200, a measurement unit 300, and a control unit 400. The balance circuit 200 adjusts an amount of charge of each battery cell 100. The measurement unit 300 measures a voltage of the battery cell 100. The control unit 400 controls operation of the balance circuit 200, based on a voltage measured by the measurement unit 300. Furthermore, when the battery cell 100 is charged, the control unit 400 specifies a voltage-maximum cell of which a voltage is at the maximum, based on the voltage measured by the measurement unit 300. Furthermore, when a first condition is not satisfied that the voltage of the voltage-maximum cell is a second reference voltage $V_2$ or above, the control unit 400 continues to perform the charge. On the other hand, when the first condition is satisfied, by operating the balance circuit 200, the voltage of the voltage-maximum cell is dropped. A detailed description is provided below.

Here, when the battery pack 10 according to the first embodiment or the second embodiment is repeatedly both charged and discharged, the battery cells 100 do not necessarily equally deteriorate. In this case, it is expected that the battery cells 100 come to differ in capacity. If a capacity-minimum cell (a) becomes additionally small in capacity, there is a likelihood that the battery cell 100 will be in the same state as in the comparative example described in the first embodiment. According to the third embodiment, the battery pack 10 has a control circuit 20 so that the battery pack 10 can cope with changes in capacity over time.

As illustrated in Fig. 8, the battery pack 10 according to the third embodiment has the control circuit 20 in addition to the battery cell 100. The control circuit 20 includes the balance circuit 200, the measurement unit 300, the control unit 400 and a switch 500.

The battery cell 100 is, for example, recycled, in the same manner as that according to the second embodiment. Furthermore, the multiple battery cells 100 are connected in series to one another in a state where they become charged up to the full charge capacity. Because of deterioration over time, the available capacity $C_a$ of the capacity-minimum cell (a) out of the battery cells 100 is assumed to be smaller than when recycled.

Furthermore, the control circuit 20 is connected to the battery cells 100 that are connected in series to one another. The control circuit 20 has a battery positive terminal 160, a battery negative terminal 180, an external positive terminal 720, and an external negative terminal 740. The battery positive terminal 160 is connected to a positive electrode of one of the battery cells 100 that are connected in series to one another. Furthermore, the battery negative terminal 180 is connected to a negative electrode of the other of the battery cells 100 that are connected in series to one another.

The battery positive terminal 160 is connected to the external positive terminal 720 for connection to an external apparatus that uses the battery pack 10, through wiring (the reference numeral thereof is not illustrated) within the control circuit 20. Furthermore, in the same manner, the battery negative terminal 180 is also connected to the external negative terminal 740.

The switch 500 for stopping the charge or the discharge is provided between the battery positive terminal 160 and the external positive terminal 720. The switch 500 is provided, for example, between the battery positive terminal 160 to the side of the battery cell 100 and the external positive terminal 720. In this case, the switch 500 is, for example, a P-channel Metal Oxide Semiconductor Field Effect Transistor (MOSFET). The two P-channel MOSFETs are provided within the switch 500. Accordingly, one MOSFET is used to control the charge. On the other hand, the other MOSFET is used to control the discharge. Furthermore, in the switch 500, each MOSFET is connected to the measurement unit 300.

Moreover, if the switch 500 is an N-channel MOSFET, the switch 500 is arranged between the battery negative terminal 180 and the external negative terminal 740. In addition, the switch 500 may be, for example, an Insulated Gate Bipolar Transistor (IGBT), a relay, or a breaker.

The measurement unit 300 measures the voltage and the current in the multiple battery cells 100. The measurement unit 300 is connected to the battery cell 100 through the balance circuit 200.

Furthermore, the balance circuit 200 is provided to the side of the battery cell 100 rather than to the side of the measurement unit 300. In order to adjust an amount of charge of each battery cell 100, the balance circuit 200 is provided between each battery cell 100.

The control unit 400 is connected toward the external positive terminal 720 and toward the external negative terminal 740 of the measurement unit 300. The control unit 400 controls the operation of the balance circuit 200, based on the voltage measured by the measurement unit 300. The control unit 400 has a calculation unit (not illustrated) that performs arithmetic processing, based on the voltage or the current measured by the measurement unit 300. Furthermore, the control unit 400 has a communication unit (not illustrated) for transmitting a signal from the control unit 400 to the external apparatus (not illustrated) and receiving a signal from the external apparatus. An external-communication terminal 760 for transmitting and receiving a signal to and from the external apparatus is connected to the control unit 400.

Furthermore, the measurement unit 300, the control unit 400, and the switch 500 function as a protection circuit in order to improve safety and a charge and discharge cycle life. If the charge is performed with a voltage exceeding an overcharge protection voltage $V_{OP}$, the measurement unit 300, the control unit 400, and the switch 500 force the charge of the battery cell 100 to be terminated. In addition, the control unit 400 has a storage unit (not illustrated) that stores the second reference voltage $V_2$ and the like that are described below. Moreover, operation of the control unit 400 relating to the charge is described below.

In this manner, according to the third embodiment, the multiple battery cells 100 and the control circuit 20 are included and packaged into the battery pack 10.

Next, a method of manufacturing the battery pack 10 according to the third embodiment is described. The manufacturing method according to the third embodiment is the same as the manufacturing method according to the first embodiment except that a package step (S140) is different.

According to the third embodiment, in the package step (S140), first, the control circuit 20 that includes the balance circuit 200, the measurement unit 300, and the control unit 400 is accommodated within an exterior body 12. At this time, the control circuit 20 may be accommodated in an assembled state, and the balance circuit 200, the measurement unit 300, and the control unit 400 may be connected to one another in the battery pack 10.

Subsequently, the battery cells 100 that are connected in series to one another after the connection step (S130) and the control circuit 20 are connected to one another. In this manner, the unnecessary discharge in the manufacturing steps can be prevented by accommodating the battery cells 100 later than the control circuit 20.

As described above, the battery pack 10 according to the third embodiment is obtained.

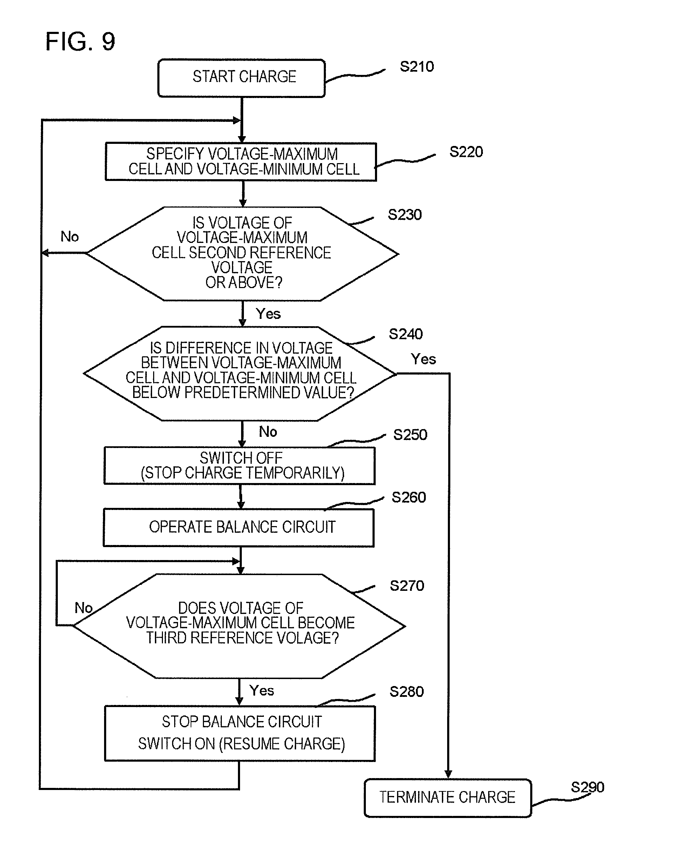

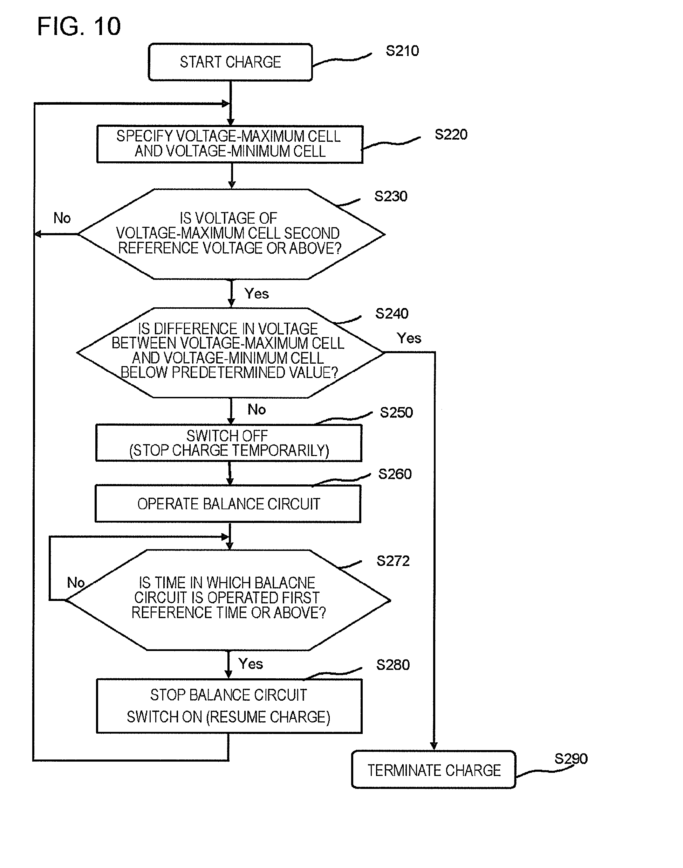

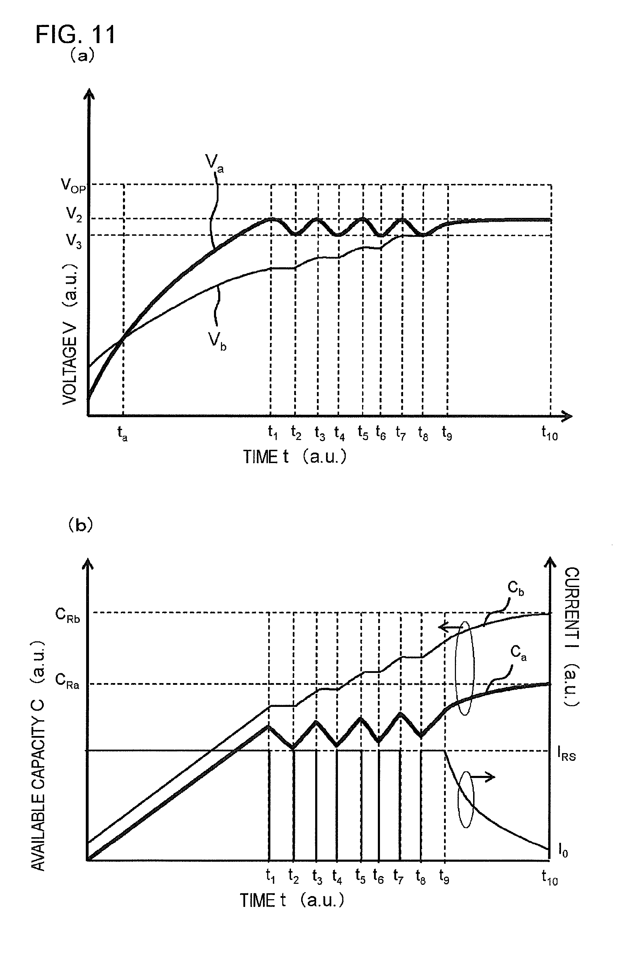

Next, a method of charging the battery pack 10 is described referring to Fig. 9 to Fig. 11. Fig. 9 and Fig. 10 are flowcharts for describing the charging method according to the third embodiment. Moreover, Fig. 10 is a modification example of Fig. 9. Fig. 11 is a view for describing the charging method according to the third embodiment. The charging method according to the third embodiment includes the following steps. First, the battery pack 10 and an external charger (not illustrated) are connected to each other, and the multiple battery cells 100 start to be charged (S210). Here, as the charge starts, the measurement unit 300 starts to measure the voltage of the multiple battery cells 100 that are connected in series to one another. Subsequently, the control unit 400 specifies the voltage-maximum cell of which the voltage is at the maximum and a voltage-minimum cell of which the voltage is at the minimum, based on the voltage measured by the control unit 300 (S220). Subsequently, the control unit 400 determines whether the first condition is satisfied that the voltage of the voltage-maximum cell is the second reference voltage $V_2$ or above (S230). Subsequently, when determining that the first condition is not satisfied (No in S230), the control unit 400 continues the charge. On the other hand, when determining that the first condition is satisfied (Yes in S230), the control unit 400 drops the voltage of the voltage-maximum cell by operating the balance circuit 200 (a balance circuit operation step, S250). A detailed description is provided below.

Moreover, the second reference voltage $V_2$ that is referred to below may be equal to a first reference voltage $V_1$.

First, in Fig. 8, the switch 500 operates to switch to the charge, and the external positive terminal 720 and the external negative terminal 740 are connected to the positive electrode and the negative electrode of the external charger that is a power supply source (not illustrated).

Accordingly, the multiple battery cells 100 start to be charged (S210). The charge is performed with the constant voltage and the constant current. Here, for example, the charge voltage is set to $NV_2$ in such a manner that the voltage of the battery cell 100 becomes the second reference voltage $V_2$. Furthermore, the charge current is set to $I_{RS}$. The charge starts, and at the same time the measurement unit 300 measures the voltage of multiple battery cells 100 that are connected in series to one another. Furthermore, the measurement unit 300 measures the current in the battery cell 100 as well.

Subsequently, the control unit 400 specifies the voltage-maximum cell of which the voltage is at the maximum and a voltage-minimum cell of which the voltage is at the minimum, based on the voltage measured by the measurement unit 300 (S220). Moreover, the switch may be made between the voltage-maximum cell and the voltage-minimum cell during the measurement.

Here, Fig. 11(a) illustrates a relationship between time and a voltage of the battery cell 100 after starting charge, according to the third embodiment. Moreover, in the same manner as in the first embodiment, the capacity-minimum cell and the capacity-maximum cell are defined as (a) and (b), respectively. Furthermore, time t is set to be independent of the value according to the first embodiment.

At this time, all the battery cells 100 are connected in series to one another. Because of this, the battery cells 100 are all equal in terms of the current flowing in them. Therefore, among the battery cells 100, because the available capacity $C_a$ of the capacity-minimum cell (a) is rapidly increased to the full charge capacity, a voltage $V_a$ is increased more rapidly than a voltage $V_b$ of the capacity-maximum cell (b). Because of this, at time $t_a$, the voltage $V_a$ of the capacity-minimum cell (a) is larger than the voltage $V_b$ of the capacity-maximum cell (b). Therefore, at and after the time $t_a$, the control unit 400 specifies the capacity-minimum cell (a) as the "voltage-maximum cell." On the other hand, at and after the time $t_a$, the control unit 400 specifies the capacity-maximum cell (b) as the "voltage-minimum cell." The capacity-minimum cell (a) and the capacity-maximum cell (b) are hereinafter referred to as the "voltage-maximum cell" and the "voltage-minimum cell," respectively. Moreover, according to the second embodiment, because the two unit cells within the battery cell 100 are connected in parallel to each other, a larger amount of current flows in the unit cell that is smaller in deterioration.

Furthermore, Fig. 11 (b) illustrates a relationship between time and available capacity of the battery cell 100 after starting charge and a relationship between time and current in the battery cell 100, according to the third embodiment. As illustrated in Fig. 11(b), the available capacity of the capacity-minimum cell is illustrated as $C_a$ with a bold solid line. Furthermore, the available capacity of the capacity-maximum cell is illustrated as $C_b$ with a thin solid line. As illustrated in Fig. 11(b), because the constant current charge is performed, the current in each of the battery cells 100 that are being charged is constant charge current $I_{RS}$. Therefore, the available capacity of each battery cell 100 increases linearly.

Subsequently, the control unit 400 determines whether the first condition is satisfied that the voltage of the voltage-maximum cell is the second reference voltage $V_2$ or above (S230). The "second reference voltage $V_2$" is stored in the storage unit of the control unit 400. The "second reference voltage $V_2$" here, for example, is equal to the first reference voltage $V_1$ that is used when the battery cell 100 is charged up to the full charge capacity, in the charge step in the step of manufacturing the battery pack 10. Specifically, the "second reference voltage $V_2$" is, for example, a rated charge voltage. Accordingly, because the voltage-maximum cell is not charged up to the full charge capacity, the deterioration of the voltage-maximum cell can be suppressed.

Moreover, as described below, because the "second reference voltage $V_2$" is a reference voltage for determining whether to operate the balance circuit 200, the "second reference voltage $V_2$" does not necessarily need to be the same as the desired rated charge voltage. That is, the "second reference voltage $V_2$" may be the rated charge voltage or above, but below the overcharge protection voltage $V_{OP}$. Moreover, the "overcharge protection voltage $V_{OP}$" is stored in the storage unit of the control unit 400.

Subsequently, when the voltage of the voltage-maximum cell is below the second reference voltage $V_2$ and the first condition is not satisfied (No in S230), the control unit 400 continues the charge.

On the other hand, when the voltage $V_a$ of the voltage-maximum cell is the second reference voltage $V_2$ or above and the first condition is satisfied (Yes in S230), the control unit 400 determines whether a second condition is satisfied that a difference in voltage between the voltage-maximum cell and the voltage-minimum cell is below a predetermined value (S240). The "predetermined voltage" here is determined based on an allowed range in the difference in voltage between the voltage-maximum cell and the voltage-minimum cell, precision of the measurement by the measurement unit 300, time allowed for charging or the like. Specifically, the "predetermined voltage" is, for example, a limit value for the precision of the measurement by the measurement unit 300.

Here, as assumed above, the capacity-minimum cell (a) that is the voltage-maximum cell deteriorates further than when the recycling is performed. Because of this, as illustrated in Fig. 11(a), the voltage $V_a$ of the capacity-minimum cell (a) that is the voltage-maximum cell increases more rapidly than the voltages of the other cells and increases most rapidly to the second reference voltage $V_2$.

As illustrated in Fig. 11(a), at time $t_1$, the voltage $V_a$ of the voltage-maximum cell is the second reference voltage $V_2$. Therefore, the voltage $V_2$ of the voltage-maximum cell is in a state of satisfying the first condition. On the other hand, the voltage $V_b$ of the voltage-minimum cell does not reach the second reference voltage $V_2$. Furthermore, because the difference in voltage between the voltage-maximum cell and the voltage-minimum cell is large, the second condition is not satisfied. Therefore, at the time $t_1$, the first condition is satisfied and the second condition is not satisfied.

Furthermore, as illustrated in Fig. 11(b), at the time $t_1$, the available capacity $C_a$ of the voltage-maximum cell is not increased up to the full charge capacity $C_{Ra}$. Furthermore, the available capacity $C_b$ of the voltage-minimum cell also is not increased up to the full charge capacity $C_{Rb}$. That is, the voltage-minimum cell is in a state of not being yet sufficiently charged. As in the first embodiment, in performing the recharge immediately after manufacturing the battery pack 10, all the battery cells 100 become charged up to the full charge capacity at almost the same timing. However, according to the present embodiment, because of deterioration, the battery cells 100 differ in the timing at which the battery cells 100 become charged up to the full charge capacity.

In this manner, when the first condition is satisfied and the second condition is not satisfied (No in S240), as described below, the control unit 400 temporarily stops the charge (S250) and operates the balance circuit 200 (the balance circuit operation step, S260).

First, the control unit 400 transmits a signal for stopping the charge to the switch 500 through the measurement unit 300. Here, the measurement unit 300 is connected to each battery cell 100 through the balance circuit 200. In the battery pack 10, if the balance circuit 200 is operated while continuing the charge, in the interval, the measurement unit 300 cannot measure the voltage of the battery cell 100 correctly. Because of this, it cannot be recognized that the battery cell 100 becomes overcharged. Because of this, if the voltage of each battery cell 100 approaches the overcharge state, the timing when detecting the battery cell 100 in the overcharge state is delayed, resulting in danger. Therefore, before the balance circuit operation step (S260), the control unit 400 can safely operate the balance circuit 200 by temporarily stopping charging of the battery cell 100.

Subsequently, after the temporal stopping of the charge (S250) is performed, the control unit 400 operates the balance circuit 200 (S260).

Here, in Fig. 11 (a) and Fig. 11(b), the balance circuit operation step (S260) is during a period of time from the time $t_1$ to time $t_2$. As illustrated in Fig. 11(a), from the time $t_1$ to the time $t_2$, the voltage-maximum cell consumes electric power because of internal resistance of the balance circuit 200. Accordingly, the voltage $V_a$ of the voltage-maximum cell drops. On the other hand, the other battery cells 100, such as the voltage-minimum cell, have no load applied thereto and are not charged as described above, while the balance circuit 200 is not operated. Because of this, in each of the other battery cells 100, only the voltage drop due to the internal resistance of its own (of the battery cell 100) or the minute voltage drop, such as self-discharge occurs. Therefore, the described-above voltage drop in the voltage-maximum cell is larger than the voltage drop in the other battery cells 100. Accordingly, the voltage $V_a$ of the voltage-maximum cell and the voltage $V_b$ of the voltage-minimum cell can be gradually made to approach each other. Moreover, as illustrated in Fig. 11(b), from the time $t_1$ to the time $t_2$, for example, the available capacity $C_b$ of the voltage-minimum cell remains constant. Furthermore, because the charge is not performed, the current is also 0.

As illustrated in Fig. 9, in the balance circuit operation step (S260), for example, the control unit 400 determines whether the voltage $V_a$ of the voltage-maximum cell becomes a third reference voltage $V_3$ that is lower than the second reference voltage $V_2$ (S270). Furthermore, as illustrated in Fig. 10, in the balance circuit operation step (S260), after operating the balance circuit 200, the control unit 400 determines whether the time in which the balance circuit 200 is operated becomes a first reference time or above (S272). Furthermore, the control unit 400 may determine whether the two conditions are satisfied at the same time. Moreover, in the third embodiment, the condition in Fig. 9 is set as being applied. Moreover, if the internal resistance of the balance circuit 200 is large and the drop in the voltage $V_a$ of the voltage-maximum cell is slow, it is preferable that the condition in Fig. 10 be applied.

When the voltage $V_a$ of the voltage-maximum cell becomes the third reference voltage $V_3$ (Yes in S270), the control unit 400 transmits a signal for resuming the charge to the switch 500 through the measurement unit 300. At the same time, the control unit 400 stops the balance circuit 200 and resumes charging the battery cell 100 (S280).

Here, in Fig. 11 (a) and Fig. 11(b), at the time $t_2$, the voltage $V_a$ of the voltage-maximum cell becomes the third reference voltage $V_3$. Furthermore, a state in which the charge is resumed is during a period of time from the time $t_2$ to time $t_3$. As illustrated in Fig. 11(a), the voltage $V_a$ of the voltage-maximum cell and the voltage $V_b$ of the voltage-minimum cell increase again together. Furthermore, as illustrated in Fig. 11(b), the available capacity $C_a$ of the voltage-maximum cell and the available capacity $C_b$ of the voltage-minimum cell increase again. In addition, the current in the voltage-maximum cell and the voltage-minimum cell becomes the charge current $I_{RS}$.

In this manner, by setting a condition, such as one that the voltage $V_a$ of the voltage-maximum cell is the second reference voltage $V_2$, the control unit 400 can terminate the balance circuit operation step (S260) and resume the charge.

Moreover, the condition for terminating the balance circuit operation step (S260) is not limited to the condition described above, and the same condition as the second condition that the difference in voltage between the voltage-maximum cell and the voltage-minimum cell is below the predetermined voltage can be applied. The condition for terminating the balance circuit operation step (S260) can be properly adjusted, considering the load on the balance circuit 200.

After the balance circuit is stopped (after S280), S220 to S280 are repeatedly performed. As illustrated in Fig. 11(a), from the time $t_2$ to time $t_8$, the voltage $V_a$ of the voltage-maximum cell repeatedly both increases due to the charge and decreases in the balance circuit operation step (S260). On the other hand, the voltage $V_b$ of the voltage-minimum cell repeatedly both increases due to the charge and maintains the voltage in the balance circuit operation step (S260). Accordingly, the voltage $V_a$ of the voltage-maximum cell and the voltage $V_b$ of the voltage-minimum cell can be gradually made to approach each other. Furthermore, as illustrated in Fig. 11(b), the available capacity $C_a$ of the voltage-maximum cell can be gradually made to approach the full charge capacity $C_{Ra}$ and the available capacity $C_b$ of the voltage-minimum cell can be gradually made to approach the full charge capacity $C_{Rb}$.

Moreover, while the steps S220 to S280 are repeatedly performed, the voltage $V_a$ of the voltage-maximum cell drops and thus the different battery cell 100 may take place of the voltage-maximum cell. In such a case, the control unit 400 determines whether the first condition and the like are satisfied, with the voltage of a new voltage-maximum cell being set to be $V_a$.

By setting the second condition in this manner, the charge and the balance circuit operation step (S260) are repeatedly performed until the difference in voltage between the voltage-maximum cell and the voltage-minimum cell becomes lower than the predetermined voltage. Therefore, here, the second condition that "the difference in voltage between the voltage-maximum cell and the voltage-minimum cell becomes lower than the predetermined voltage" is a condition for terminating the charge when the charge is repeatedly performed.

Subsequently, the second condition is set as a state of being at the time $t_8$ in Fig. 11(a) and Fig. 11(b). The state of being at the time $t_8$ in Fig. 11(a) and Fig. 11(b) is a state in which the balance circuit 200 is stopped (S280). As described above, the control unit 400 stops the balance circuit 200 and resumes charging the battery cell 100.

As illustrated in Fig. 11(b), from the state of being at time $t_9$, all the battery cells 100 within the battery pack 10 approaches a full charge capacity. Because of this, each battery cell 100 becomes difficult to charge, and the current starts to decrease. That is, from the time $t_9$, the charge becomes the constant voltage charge. As illustrated in Fig. 11(a), from the state of being at the time $t_9$, the voltage $V_a$ of the voltage-maximum cell and the voltage $V_b$ of the voltage-minimum cell gradually increase.

In Fig. 11 (a), at time $t_{10}$, for example, the voltage $V_a$ of the voltage-maximum cell is equal to the second reference voltage $V_2$. Furthermore, the difference in voltage between the voltage-maximum cell and the voltage-minimum cell is almost 0. Therefore, because the first condition is satisfied and the second condition is satisfied (Yes in S240), the control unit 400 transmits the signal for stopping the charge to the switch 500 through the measurement unit 300 and terminates the charge. At this time, the control unit 400 may transmit the signal for stopping the charge to the external charger through the external-communication terminal 760 without transmitting the signal to the switch 500.

As described above, the charge of the battery pack 10 according to the third embodiment can be controlled.

Next, an effect according to the third embodiment is described.

According to the third embodiment, the same effect as that according to the first embodiment can be obtained at the time of manufacturing. However, when the battery pack 10 is repeatedly both charged and discharged, it is considered that each battery cell 100 deteriorates. In this case, the battery cells 100 do not necessarily equally deteriorate. Furthermore, it is expected that the battery cells 100 differ in full charge capacity. If the full charge capacity $C_{Ra}$ of the capacity-minimum cell (a) becomes additionally small, there is a likelihood that the battery cell 100 will be in the same state as in the comparative example described in the first embodiment.

According to the third embodiment, in charging the battery pack 10 after using up the battery pack 10, when the first condition is satisfied that the voltage $V_a$ of the voltage-maximum cell is the second reference voltage $V_2$ or above, the control unit 400 operates the balance circuit 200. Accordingly, the voltage $V_a$ of the voltage-maximum cell drops. Therefore, the voltage-maximum cell can be prevented from being overcharged. Furthermore, the voltage $V_a$ of the voltage-maximum cell can be made to approach the voltage of the other battery cells 100.

In this manner, according to the third embodiment, an amount of charge can be compensated with respect to change over time in full charge capacity.

Furthermore, according to the third embodiment, even though the full charge capacity $C_{Ra}$ of the capacity-minimum cell (a) becomes further small because of deterioration over time, the charge is not terminated in a state where the voltage $V_a$ of the capacity-minimum cell (a) is as high as the overcharge protection voltage $V_{OP}$, that is, in a state where the capacity-minimum cell (a) is in an overcharge state. Therefore, progress of the deterioration of the capacity-minimum cell (a) can be suppressed.

According to the third embodiment, the case is described above in which after it is determined that the first condition is satisfied, the charge is resumed, but the balance circuit 200 may continue to be operated until the second condition is satisfied that the difference in voltage between the voltage-maximum cell and the voltage-minimum cell is below the predetermined voltage.

Furthermore, according to the third embodiment, the case is described in which when the charge is repeatedly performed, the charge is terminated using the second condition, but a charge control system or a charge method in which the user optionally terminates the charge using only the first condition may be possible.

Furthermore, the charge termination condition described above is not limited to the second condition. The charge termination condition, for example, may be a third condition that the first condition is satisfied and an integration value of the number of times that the balance circuit 200 operates during the charge is a predetermined value or above. Furthermore, the charge termination condition, for example, may be a fourth condition that added-up charge time in which the charge is performed during the charge is longer than a second reference time that is longer than the first reference time. Furthermore, the charge termination condition, for example, may be a fifth condition that the current in each battery cell 100 is reference current or less.

Furthermore, according to the third embodiment, the case is described in which the charge is temporarily stopped in the balance circuit operation step (S260), but if the balance circuit 200 and the measurement unit 300 as separate systems are connected to the battery cell 100, the charge does not need to be temporarily stopped in the balance circuit operation step (S260). In this case, a charge control system, or a charge method may be possible in which the other battery cells 100 continue to be charged by dropping only the voltage of the voltage-maximum cell with balance circuit 200.

(Fourth Embodiment)

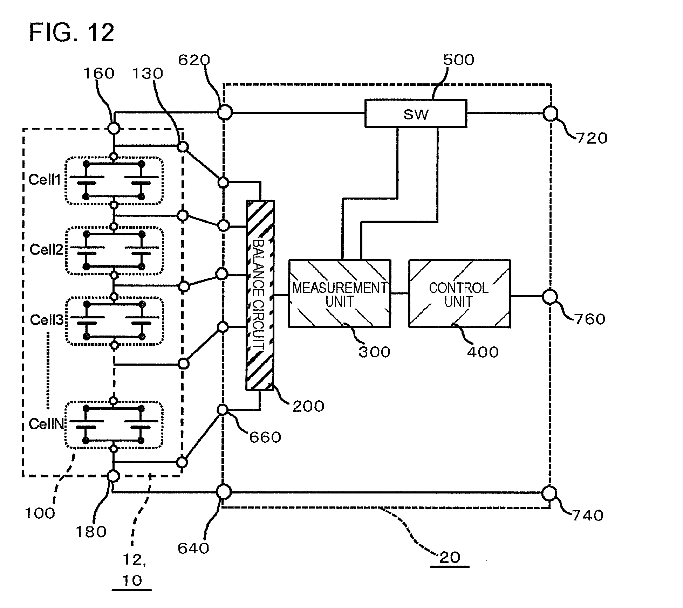

Fig. 12 is a circuit diagram illustrating configurations of a battery pack 10 and a control circuit 20 according to a fourth embodiment. The fourth embodiment is the same as the third embodiment except that the control circuit 20 is provided outside of the battery pack 10. A detailed description is provided below.

As illustrated in Fig. 12, the control circuit 20 is provided outside of the battery pack 10. The control circuit 20, for example, is provided on a charger (not illustrated) and the like, independent of the battery pack 10. Furthermore, the control circuit 20 may be provided within a usable apparatus that is used when using the battery pack 10 after discharging.

Multiple recycled battery cells 100 are connected in series to the battery pack 10 the same as those according to the second embodiment. An external positive terminal 160 and an external negative terminal 180 of the battery pack 10 are provided in the battery pack 10.

Furthermore, a measurement terminal 130 for detecting a voltage of each battery cell 100 is provided between a positive terminal (120) and a negative terminal (140) of adjacent battery cells 100.

Furthermore, the control circuit 20 includes a balance circuit 200, a measurement unit 300 and a control unit 400. The balance circuit 200 is provided toward the battery pack 10 of the control circuit 20. Furthermore, a control circuit positive terminal 620 and a control circuit negative terminal 640 are provided toward the battery pack 10 of the control circuit 20. The control circuit positive terminal 620 is connected to an external positive terminal 160 of the battery pack 10 through wiring (the reference numeral thereof is not illustrated). Furthermore, the control circuit negative terminal 640 is connected to the external negative terminal 180 of the battery pack 10 through the wiring (the reference numeral thereof is not illustrated). Accordingly, electric power for the charge is supplied from the control circuit 20 to the battery pack 10.

Furthermore, a balance circuit terminal 660 of the balance circuit 200 is provided in the control circuit 20. The balance circuit terminal 660 is connected to the measurement terminal 130 of the battery cell 100 through the wiring (the reference number thereof is not illustrated). Accordingly, even though the control circuit 20 is provided outside of the battery pack 10, the control unit 400 can control each battery cell 100 by operating the balance circuit 200.

According to the fourth embodiment, the measurement terminal 130 for detecting the voltage of each battery cell 100 is provided in the battery pack 10. On the other hand, the control circuit 20 is provided outside of the battery pack 10. The balance circuit 200 is connected to the measurement terminal 130 of each battery cell 100 through the wiring. Accordingly, the same effect as that according to the third embodiment can be obtained.

(Fifth Embodiment)

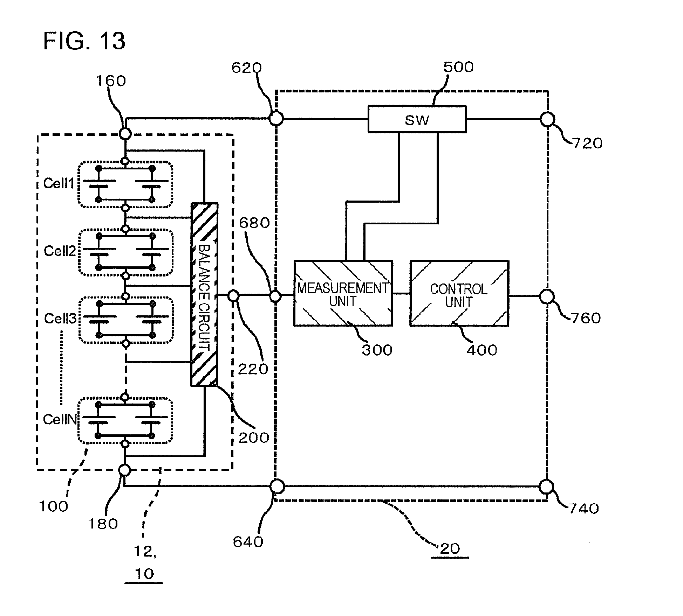

Fig. 13 is a circuit diagram illustrating configurations of a battery pack 10 and a control circuit 20 according to a fifth embodiment. The fifth embodiment is the same as the fourth embodiment except that in the control circuit 20, elements other than a balance circuit 200 are provided outside of the battery pack 10. A detailed description is provided below.

As illustrated in Fig. 12, the balance circuit 200 is provided within the battery pack 10. On the other hand, except for the balance circuit 200, the control circuit 20 that includes a measurement unit 300 and a control unit 400 is provided outside of the battery pack 10.

Within the battery pack 10, the balance circuit 200 is provided between each battery cell 100. An external positive terminal 160 and an external negative terminal 180 for charging and discharging the battery pack 10 are provided in the battery pack 10. In addition, a balance circuit terminal 220 for transmitting a signal to the balance circuit 200 and receiving a signal from the balance circuit 200 is provided.

A measurement unit 300 is provided toward the battery pack 10 of the control circuit 20. Furthermore, a control circuit positive terminal 620 and a control circuit negative terminal 640 of the control circuit 20 are provided toward the battery pack 10 of the control circuit 20. The control circuit positive terminal 620 and the control circuit negative terminal 640 of the control circuit 20 are connected to the external positive terminal 160 and the external negative terminal 180 of the battery pack, respectively.

A measurement signal terminal 680 is provided toward the battery pack 10 of the measurement unit 300. The measurement signal terminal 680 is connected to the balance circuit terminal 220 through wiring (the reference numeral thereof is not illustrated). Accordingly, the control circuit 20 can transmit and receive a signal for operating the balance circuit 200 or signals for the voltage and the current from the battery cell 100.

According to the fifth embodiment, the balance circuit 200 is provided within the battery pack 10. On the other hand, in the control circuit 20, elements other than the balance circuit 200 are provided outside of the battery pack 10. Even with this configuration, the same effect as that according to the first embodiment or the same as that according to the second embodiment can be obtained.

According to the fourth embodiment and the fifth embodiment, the case is described in which the control circuit 20 is provided outside of the battery pack 10, but in addition to this, various configurations are possible. For example, only the control unit 400 may be provided outside of the battery pack 10.

According to the embodiments described above, the case is described in which the battery cells 100 are connected in series to one another in a full charge capacity, but considering safety, the battery cells 100 may be connected after discharging the battery cells 100 to a predetermined level.

The embodiments of the present invention are described above referring to the drawings, but these are examples of the present invention and various configurations other than those described above can be employed.

This application claims the benefit of earlier filing date and right of priority to Japanese Patent Application No. 2011-152373, filed on July 8, 2011, the contents of which are incorporated by reference herein in its entirety.

**Claims**

1.  A method of manufacturing a battery pack comprising:

    a charge step of individually charging battery units that differ in full charge capacity to charge the battery units up to the full charge capacity; and
    a connection step of connecting in series the multiple battery units that reach the full charge capacity.

2.  The method of manufacturing a battery pack according to claim 1,
    wherein the multiple battery units are recycled.

3.  The method of manufacturing a battery pack according to claim 1 or 2,
    wherein in the charge step, a voltage of the battery unit that is at the full charge capacity is a first reference voltage that is below an overcharge protection voltage.

4. The method of manufacturing a battery pack according to any one of claims 1 to 3, further comprising:

a package step of accommodating the multiple battery units within an exterior body and providing an external positive terminal that is connected to a positive terminal of the battery unit that is provided nearest to a positive electrode and an external negative terminal that connects to a negative terminal of the battery unit that is provided nearest to a negative electrode in such a manner that the external positive terminal and the external negative terminal are exposed from the exterior body, which follows the connection step.

5. The method of manufacturing a battery pack according to claim 4,
wherein in the package step, a measurement terminal for detecting a voltage of each battery unit is provided.

6. The method of manufacturing a battery pack according to claim 4,
wherein in the package step, a balance circuit for being connected to each battery unit and adjusting an amount of charge of each battery unit is provided.

7. The method of manufacturing a battery pack according to claim 6,
wherein in the package step, a measurement unit that measures a voltage of the battery unit and a control unit that controls operation of the balance circuit, based on the voltage measured by the measurement unit are provided,
wherein when charge is performed on the battery unit, the control unit specifies a voltage-maximum unit of which the voltage is at the maximum, based on the voltage measured by the measurement unit,
wherein when a first condition is not satisfied that the voltage of the voltage-maximum unit is a second reference voltage or above, the control unit continues the charge, and
wherein when the first condition is satisfied, the control unit operates the balance circuit, thereby dropping the voltage of the voltage-maximum unit.

8. The method of manufacturing a battery pack according to claim 7,
wherein when the first condition is satisfied, the control unit temporarily stops the charge and operates the balance circuit.

9. The method of manufacturing a battery pack according to claim 7 or 8,
wherein after the first condition is satisfied and thus the control unit operates the balance circuit, when the voltage-maximum unit becomes a third reference voltage that is lower than the second reference voltage, the control unit stops the balance circuit and resumes the charge.

10. The method of manufacturing a battery pack according to any one of claims 7 to 9,
wherein after the first condition is satisfied and thus the control unit operates the balance circuit, when the time in which the balance circuit is operated becomes a first reference time or above, the control unit stops the balance circuit and resumes the charge.

11. A battery pack comprising:

multiple battery units that are connected in series to one another,
wherein the multiple battery units individually differ in full charge capacity, and
wherein amounts of difference, each of which results from subtracting a current amount of charge from the full charge capacity of each of the battery units, are mutually substantially the same.

12. The battery pack according to claim 11, wherein the multiple battery units are recycled.

13. The battery pack according to claim 11 or 12, further comprising:

a measurement terminal for detecting a voltage of each of the battery units.

14. The battery pack according to claim 11 or 12, further comprising:

a balance circuit for being connected to each of the battery units and adjusting an amount of charge of the battery unit.

**15.** The battery pack according to claim 14, further comprising:

a measurement unit that measures a voltage of the battery unit; and
a control unit that controls operation of the balance circuit, based on the voltage measured by the measurement unit,
wherein when charge is performed on the battery unit, the control unit specifies a voltage-maximum unit of which the voltage is at the maximum, based on the voltage measured by the measurement unit,
wherein when a first condition is not satisfied that the voltage of the voltage-maximum unit is a second reference voltage or above, the control unit continues the charge, and
wherein when the first condition is satisfied, the control unit operates the balance circuit, thereby dropping the voltage of the voltage-maximum unit.

**16.** The battery pack according to claim 15,
wherein when the first condition is satisfied, the control unit temporarily stops the charge and operates the balance circuit.

**17.** The battery pack according to claim 15 or 16,
wherein after the first condition is satisfied and thus the control unit operates the balance circuit, when the voltage-maximum unit becomes a third reference voltage that is lower than the second reference voltage, the control unit stops the balance circuit and resumes the charge.

**18.** The battery pack according to any one of claims 15 to 17,
wherein after the first condition is satisfied and thus the control unit operates the balance circuit, when the time in which the balance circuit is operated becomes a first reference time or above, the control unit stops the balance circuit and resumes the charge.

FIG. 1

FIG. 2

```
                    ┌─────────────────────┐
                    │        START        │
                    └─────────────────────┘
                               │
                               ▼
        ┌─────────────────────────────────────┐
        │   PREPARE BATTERY CELLS THAT         │────── S110
        │   DIFFER IN FULL CHARGE CAPACITY     │
        └─────────────────────────────────────┘
                               │
                               ▼
        ┌─────────────────────────────────────┐
        │ CHARGE BATTERY CELL INDIVIDUALLY UP  │────── S120
        │      TO FULL CHARGE CAPACITY         │
        └─────────────────────────────────────┘
                               │
                               ▼
        ┌─────────────────────────────────────┐
        │   CONNECT BATTERY CELLS IN SERIES    │────── S130
        └─────────────────────────────────────┘
                               │
                               ▼
        ┌─────────────────────────────────────┐
        │       PACKAGE BATTERY CELLS          │────── S140
        │        INTO BATTERY PACK             │
        └─────────────────────────────────────┘
                               │
                               ▼
                    ┌─────────────────────┐
                    │         END         │
                    └─────────────────────┘
```

## FIG. 3

(a)

(b)

FIG. 4

(a)

(b)

# FIG. 5

(a)

(b)

## FIG. 6

(a)

(b)

FIG. 7

```
          ┌──────────────────┐
          │      START       │
          └──────────────────┘
                   │
                   ▼
   ┌──────────────────────────────────┐
   │  PREPARE RECYCLED BATTERY CELLS  │ ──── S112
   └──────────────────────────────────┘
                   │
                   ▼
   ┌──────────────────────────────────┐
   │ CHARGE BATTERY CELL INDIVIDUALLY │ ──── S120
   │     UP TO FULL CHARGE CAPACITY   │
   └──────────────────────────────────┘
                   │
                   ▼
   ┌──────────────────────────────────┐
   │  CONNECT BATTERY CELLS IN SERIES │ ──── S130
   └──────────────────────────────────┘
                   │
                   ▼
   ┌──────────────────────────────────┐
   │       PACKAGE BATTERY CELLS      │ ──── S140
   │        INTO BATTERY PACK         │
   └──────────────────────────────────┘
                   │
                   ▼
          ┌──────────────────┐
          │       END        │
          └──────────────────┘
```

FIG. 8

FIG. 9

START CHARGE — S210

SPECIFY VOLTAGE-MAXIMUM
CELL AND VOLTAGE-MINIMUM CELL — S220

IS VOLTAGE OF
VOLTAGE-MAXIMUM
CELL SECOND REFERENCE
VOLTAGE
OR ABOVE? — S230

No

Yes

IS DIFFERENCE IN VOLTAGE
BETWEEN VOLTAGE-MAXIMUM
CELL AND VOLTAGE-MINIMUM CELL
BELOW PREDETERMINED VALUE? — S240

Yes

No

SWITCH OFF
(STOP CHARGE TEMPORARILY) — S250

OPERATE BALANCE CIRCUIT — S260

DOES VOLTAGE OF
VOLTAGE-MAXIMUM CELL BECOME
THIRD REFERENCE VOLAGE? — S270

No

Yes

STOP BALANCE CIRCUIT
SWITCH ON (RESUME CHARGE) — S280

TERMINATE CHARGE — S290

## FIG. 10

```
                    ┌─────────────────────┐
                    │    START CHARGE     │──────── S210
                    └─────────────────────┘
                              │
                              ▼
                 ┌──────────────────────────────┐
                 │ SPECIFY VOLTAGE-MAXIMUM CELL  │──────── S220
                 │  AND VOLTAGE-MINIMUM CELL     │
                 └──────────────────────────────┘
                              │
                              ▼
                                                 S230
         No      ╱─────────────────────────╲
    ◄────────────┤     IS VOLTAGE OF         │
                 │ VOLTAGE-MAXIMUM CELL SECOND│
                 │ REFERENCE VOLTAGE OR ABOVE?│
                 ╲─────────────────────────╱
                              │ Yes
                              ▼
                                                 S240
                 ╱─────────────────────────╲      Yes
                 │   IS DIFFERENCE IN VOLTAGE│──────────────┐
                 │ BETWEEN VOLTAGE-MAXIMUM CELL│             │
                 │  AND VOLTAGE-MINIMUM CELL  │             │
                 │ BELOW PREDETERMINED VALUE? │             │
                 ╲─────────────────────────╱               │
                              │ No         S250              │
                              ▼                              │
                 ┌──────────────────────────────┐           │
                 │        SWITCH OFF             │           │
                 │  (STOP CHARGE TEMPORARILY)    │           │
                 └──────────────────────────────┘           │
                              │           S260               │
                              ▼                              │
                 ┌──────────────────────────────┐           │
                 │     OPERATE BALANCE CIRCUIT   │           │
                 └──────────────────────────────┘           │
                              │                              │
                              ▼                              │
                                             S272            │
         No      ╱─────────────────────────╲                │
    ◄────────────┤  IS TIME IN WHICH BALACNE │                │
                 │ CIRCUIT IS OPERATED FIRST  │                │
                 │  REFERENCE TIME OR ABOVE?  │                │
                 ╲─────────────────────────╱                 │
                              │ Yes        S280               │
                              ▼                               │
                 ┌──────────────────────────────┐            │
                 │    STOP BALANCE CIRCUIT       │            │
                 │ SWITCH ON (RESUME CHARGE)     │            │
                 └──────────────────────────────┘            │
                                                             ▼
                                          ┌──────────────────────┐
                                          │   TERMINATE CHARGE    │──── S290
                                          └──────────────────────┘
```

FIG. 11

(a)

(b)

FIG. 12

FIG. 13

<table>
<tr><td colspan="2" align="center">**INTERNATIONAL SEARCH REPORT**</td><td>International application No.<br>PCT/JP2012/004291</td></tr>
</table>

A. CLASSIFICATION OF SUBJECT MATTER
*H01M2/10*(2006.01)i, *H01M2/30*(2006.01)i, *H01M10/44*(2006.01)i, *H02J7/02*(2006.01)i

According to International Patent Classification (IPC) or to both national classification and IPC

B. FIELDS SEARCHED

Minimum documentation searched (classification system followed by classification symbols)
H01M2/10, H01M2/30, H01M10/44, H02J7/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2010-057265 A  (Toyota Motor Corp.),<br>11 March 2010 (11.03.2010),<br>paragraph [0029]; fig. 1<br>& WO 2010/024100 A1<br>paragraph [0039]; fig. 1<br>& CN 102138265 A | 1-9<br>10 |
| Y<br>A | JP 2009-081981 A  (Sanyo Electric Co., Ltd.),<br>16 April 2009 (16.04.2009),<br>paragraph [0005]<br>& US 2009/0085520 A1<br>paragraph [0008]<br>& EP 2043225 A2 | 1-9,11-17<br>10,18 |

[X] Further documents are listed in the continuation of Box C.  ☐ See patent family annex.

| | |
|---|---|
| *  Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| | |
|---|---|
| Date of the actual completion of the international search<br>01 August, 2012 (01.08.12) | Date of mailing of the international search report<br>14 August, 2012 (14.08.12) |
| Name and mailing address of the ISA/<br>Japanese Patent Office | Authorized officer |
| Facsimile No. | Telephone No. |

Form PCT/ISA/210 (second sheet) (July 2009)

## INTERNATIONAL SEARCH REPORT

| | International application No. |
|---|---|
| | PCT/JP2012/004291 |

C (Continuation).   DOCUMENTS CONSIDERED TO BE RELEVANT

| Category* | Citation of document, with indication, where appropriate, of the relevant passages | Relevant to claim No. |
|---|---|---|
| Y<br>A | JP 2007-128674 A  (Matsushita Electric Industrial Co., Ltd.),<br>24 May 2007 (24.05.2007),<br>entire text; all drawings<br>(Family: none) | 2-9,12-17<br>10,18 |
| Y<br>A | JP 2007-325451 A  (NEC Tokin Corp.),<br>13 December 2007 (13.12.2007),<br>entire text; all drawings<br>(Family: none) | 3-9,11-17<br>10,18 |
| Y | JP 2010-251238 A  (Sanyo Electric Co., Ltd.),<br>04 November 2010 (04.11.2010),<br>paragraphs [0059], [0071]<br>(Family: none) | 4-9 |
| Y | JP 2007-273192 A  (Toshiba Corp.),<br>18 October 2007 (18.10.2007),<br>paragraph [0110]; fig. 2<br>& US 2007/0229034 A1<br>paragraph [0106]; fig. 2<br>& EP 1841003 A1        & CN 101047263 A<br>& KR 10-2007-0098642 A | 5,13 |
| A | JP 2010-009840 A  (Panasonic Corp.),<br>14 January 2010 (14.01.2010),<br>entire text; all drawings<br>(Family: none) | 1-18 |
| A | JP 2002-354699 A  (Japan Storage Battery Co., Ltd.),<br>06 December 2002 (06.12.2002),<br>paragraphs [0006], [0012] to [0021]<br>(Family: none) | 11-18 |
| A | JP 2002-141039 A  (Shin-Kobe Electric Machinery Co., Ltd.),<br>17 May 2002 (17.05.2002),<br>paragraph [0012]<br>(Family: none) | 1-18 |
| A | JP 2004-185915 A  (Toyota Motor Corp.),<br>02 July 2004 (02.07.2004),<br>entire text; all drawings<br>& US 2006/0012330 A1    & EP 1567876 A<br>& WO 2004/051296 A1    & DE 60312207 D<br>& DE 60312207 T        & KR 10-2005-0084061 A<br>& CN 1720461 A | 1-18 |
| A | JP 2008-311213 A  (Panasonic EV Energy Co., Ltd.),<br>25 December 2008 (25.12.2008),<br>entire text; all drawings<br>& US 2008/0278114 A1 | 1-18 |

Form PCT/ISA/210 (continuation of second sheet) (July 2009)

**INTERNATIONAL SEARCH REPORT**

International application No.

PCT/JP2012/004291

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 2010-220391 A (Honda Motor Co., Ltd.), 30 September 2010 (30.09.2010), paragraph [0035] & EP 2352199 A1 paragraph [0060] & WO 2010/058839 A1 & CN 102204004 A | 11-18 |

Form PCT/ISA/210 (continuation of second sheet) (July 2009)

## INTERNATIONAL SEARCH REPORT

International application No.

PCT/JP2012/004291

| Box No. II | Observations where certain claims were found unsearchable (Continuation of item 2 of first sheet) |
|---|---|

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

| Box No. III | Observations where unity of invention is lacking (Continuation of item 3 of first sheet) |
|---|---|

This International Searching Authority found multiple inventions in this international application, as follows:

See extra sheet.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2012/004291

Continuation of Box No.III of continuation of first sheet(2)

A feature common to the invention of claim 1 and the inventions of claims 11-18 is "a cell pack wherein cell units having different full charge quantities are connected in series". The results of the international search, however, revealed that this common feature is not novel, since it has been disclosed in JP 2010-009840 A (Panasonic Corp.), 14 January 2010 (14.01.2010), full text and all drawings.

Further, there is no other common matter which is considered to be a special technical feature within the meaning of PCT Rule 13.2, second sentence, and therefore, any technical relationship within the meaning of PCT Rule 13 cannot be found among those different inventions.

Consequently, it was revealed that the above-said inventions do not comply with unity of invention.

As a result of judging special technical features with respect to claims 1-18, it is considered that two inventions linked by respective special technical features indicated below are involved.

(Invention 1) the inventions of claims 1-10

"A cell pack manufacturing method, which is provided with a charging step, wherein cell units having different full charge quantities are individually charged to be fully charged, and a connecting step, wherein the fully charged cell units are connected in series."

(Invention 2) the inventions of claims 11-18

"A cell pack, wherein a plurality of cell units connected in series are provided, full charge quantities of the cell units are different from each other, and cell unit differential quantities obtained by subtracting current charge quantities from the full charge quantities are substantially equal to each other."

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009232559 A
- JP 2009277627 A
- JP 11234916 A
- JP 2011152373 A